# EUROPÄISCHE PATENTANMELDUNG

(11) **EP 2 144 484 A1**
(43) Veröffentlichungstag der Anmeldung: **13.01.2010**
(21) Anmeldenummer: 08012312.8
(22) Anmeldetag: 08.07.2008
(51) Int. Cl.: H05K 5/06

(54) **Gerät mit einem Gehäuse und Verfahren zum Herstellen eines Gerätes**

(71) Anmelder: Siemens Aktiengesellschaft, 80333 München (DE)
(72) Erfinder: Reinhard, Alexander, 92224 Amberg (DE); Schmelz, Jürgen, 90518 Altdorf (DE)

(57) **Zusammenfassung**

Bei einem Gerät (1) mit einem Gehäuse, welches ein Volumen begrenzende Wände (2, 3, 4, 5) zur Aufnahme einer technischen Einheit aufweist, wobei das Volumen zumindest teilweise mit einer Vergussmasse (7) ausgefüllt ist, wird eine Haftfestigkeit zwischen den inneren Oberflächen der Wände (2, 3, 4, 5) und der Vergussmasse (7) durch ein in die Vergussmasse (7) eingefügtes Stabilitätselement (10) erhöht. Durch die Erhöhung der Haftfestigkeit zwischen den inneren Oberflächen (2, 3, 4, 5) und der Vergussmasse (7) kann ein derartiges Gerät (1) vorteilhaft unter harten Umweltbedingungen eingesetzt werden.

## Beschreibung

Die Erfindung betrifft ein Gerät mit einem Gehäuse, welches ein Volumen begrenzende Wände zur Aufnahme einer technischen Einheit aufweist, wobei das Volumen zumindest teilweise mit einer Vergussmasse ausgefüllt ist.

Des Weiteren betrifft die Erfindung ein Verfahren zum Herstellen eines eine technische Einheit aufweisenden Gerätes, wobei das Gerät durch ein Gehäuse mit ein Volumen begrenzenden Wänden zur Aufnahme der technischen Einheit gebildet wird, wobei das Volumen zumindest teilweise mit einer Vergussmasse über eine Öffnung des Gehäuses aufgefüllt wird.

Bei Geräten, beispielsweise Komponenten für die Automatisierungstechnik, wird vorzugsweise zur Einhausung ein Metallgehäuse verwendet. Das Metallgehäuse weist dabei vorzugsweise eine Öffnung auf. Oft besteht diese Öffnung darin, dass bei einem Metallgehäuse eine Seitenwand oder ein Deckel des Gehäuses ganz oder teilweise weggelassen wird. Über diese Öffnung kann dann in das Gehäuse eine technische Einheit eingebracht werden. Unter technischer Einheit sind z.B. eine elektronische Baugruppe oder ein pneumatisches Stellsystem zu verstehen. Im Rahmen der Erfindung besteht dabei für die Gehäuse der Geräte keine Einschränkung auf den Werkstoff Metall, jedoch wird in der Regel das Gehäuse als ein Zink-Druckgussteil mit einer vorzugsweise mattchromatierten galvanischen Oberfläche hergestellt.

Insbesondere bei galvanisierten Metallgehäusen weisen die Oberflächen der Gehäuse eine geringe Oberflächenspannung auf. Eine derartige geringe Oberflächenspannung der Oberflächen hat zum Nachteil, dass eine Haftfestigkeit von in das Gehäuse eingefüllter Vergussmasse zwischen der Vergussmasse und den inneren Oberflächen der Gehäusewände eingeschränkt ist. Unter Vergussmasse ist ein Werkstoff zu verstehen, welcher in das Volumen des Gehäuses eingefüllt wird und anschließend aushärtet. Mit der Vergussmasse innerhalb des Volumens des Gehäuses können die technischen Einheiten, beispielsweise eine elektronische Leiterplatte, vor schädlichen Umwelteinflüssen wie Staub, Wasser, Hitze, Kälteeinflüssen usw. geschützt werden. Darüber hinaus weist die Vergussmasse Isolationseigenschaften auf, welche ein Ableiten von Strömen einer elektronischen Leiterplatte gegen das Gehäuse verhindert.

Bei dem nach dem Stand der Technik bekannten Gehäuse bzw. Herstellungsverfahren für derartige Gehäuse und Geräte ist es nachteilig, dass aufgrund von beispielsweise klimatischen Einflüssen oder Witterungsgegebenheiten Ablösungen der Vergussmasse von den Oberflächen der Wände des Gehäuses auftreten. So können sich, beispielsweise aufgrund von unterschiedlicher Wärmeausdehnung bzw. dem während des Aushärtungsprozesses der Vergussmasse eintretenden Reaktionsschwund, Risse an den Grenzflächen der Gehäusewand zu der Vergussmasse bilden. Diese Risse haben dann allerdings wieder zum Nachteil, dass sie die Schutzart, Chemikalienbeständigkeit eines solchen Gerätes beeinflussen. Da beispielsweise Geräte, welche als Baugruppen für eine dezentrale Peripherie in der Automatisierungstechnik ausgestaltet sind, unter harten Umgebungsbedingungen eingesetzt werden, ist es erwünscht, dass eine Rißbildung, beispielsweise durch Alterserscheinungen des verwendeten Materials an der Grenzfläche zwischen den Gehäusewänden und der Vergussmasse nicht auftritt.

Es ist daher die Aufgabe der Erfindung, ein Gerät mit einem Gehäuse bereitzustellen, welches schädlichen Umwelteinflüssen besser standhält.

Die Aufgabe wird dadurch gelöst, dass bei einem eingangs genannten gattungsgemäßen Gerät zur Erhöhung einer Haftfestigkeit zwischen den inneren Oberflächen der Wände und der Vergussmasse ein Stabilitätselement in der Vergussmasse angeordnet ist. Als Stabilitätselement kann beispielsweise ein Kunststoffformteil in das Gehäuse eingefügt werden. Durch das entsprechend konstruierte Kunststoffformteil werden die Ablösungserscheinungen an den Grenzflächen dadurch minimiert, dass bei beispielsweise unterschiedlicher Wärmeausdehnung der Oberfläche der Vergussmasse die dabei entstehenden Kräfte durch das Kunststoffformteil verteilt bzw. absorbiert werden. Durch diese Verteilung der Kräfte wirkt sich die Beeinflussung auf die Adhäsionskräfte zwischen den Seitenwänden und der Vergussmasse weniger stark aus, so dass die Haftfestigkeit zwischen der Vergussmasse und den Seitenflächen des Gehäuses erhöht ist und damit die innerhalb des Gehäuses angeordnete technische Einheit besser gegen schädliche Umwelteinflüsse geschützt ist.

In einer bevorzugten Ausgestaltung der Erfindung ist das Stabilitätselement in zusammenhängende Segmente aufgeteilt. Eine Aufteilung des Stabilitätselements, welche beispielsweise ein flacher Rahmen mit mehreren innerhalb des Rahmens angeordneten Stegen ist, können die durch Wärmebeeinflussung in der Vergussmasse auftretenden Kräfte besser verteilt bzw. absorbiert werden.

In einer besonders bevorzugten Ausgestaltung der Erfindung weist das Stabilitätselement eine gitterförmige Struktur auf und ist flächig ausgeprägt. Dabei ist es denkbar, dass das Stabilitätselement ein netzartiges Element ist, wobei die Dicke des netzartigen Elementes gegenüber seiner flächigen Ausdehnung verhältnismäßig gering ausgestaltet ist. Da das netzartige Element wiederum viele kleine gleichmäßige Segmente aufweist, ist es vorteilhaft, dass diese Segmente aufgrund ihrer geringeren Abmessung eine kleine thermische Ausdehnung bzw. Schrumpfung erfahren. Der Reaktionsschwund im Aushärtungsprozess kann also durch die Aufteilung der Segmente verringert werden.

Nach einer weiteren Optimierung der Erfindung ist das Stabilitätselement oberflächennahe in der Öffnung des Gehäuses angeordnet. Vorzugsweise schließt dabei eine Oberkante des Stabilitätselements mit einer Füllhöhe der Vergussmasse nahezu ab. Insbesondere ist es vorteilhaft, dass dabei die Vergussmasse das Stabilitätselement mit seiner Gitterstruktur vollständig umschließt.

Wird das Stabilitätselement weiterhin derart ausgestaltet, dass zwischen einem durch eine Umlaufkante des Stabilitätselements gebildeten Rand und den inneren Oberflächen der Wände eine Fuge entsteht, in die die Vergussmasse eindringbar ist, können die auftretenden Kräfte, die zur Ablösung der Vergussmasse führen, insbesondere im Randbereich, weiter verringert werden. Ein derartig mit Vergussmasse gefüllter schmaler Fugenbereich sorgt einerseits für eine optimierte Verteilung der Kräfte während der Aushärtung und der damit verbundenen Schrumpfung der Vergussmasse und andererseits für eine Verringerung der Volumen- und der damit einhergehenden Längenänderung.

Bevorzugt besteht der Werkstoff für die Vergussmasse aus einem Kunstharz. Kunstharz zeichnet sich durch seine guten Vergießeigenschaften und Fließeigenschaften während eines Herstellungsprozesses eines derartigen Gerätes aus.

Für das eingangs genannte Verfahren wird die eingangs genannte Aufgabe dadurch gelöst, dass zur Erhöhung einer Haftfestigkeit zwischen den Seitenflächen und der Vergussmasse ein Stabilitätselement vor Vergießen der Vergussmasse in das Volumen eingefügt wird. Durch das Einfügen des Stabilitätselementes, welches vorzugsweise in mehrere zusammenhängende Einzelsegmente aufgeteilt ist, kann sich die Vergussmasse nach dem Vergießen gleichmäßig an das Stabilitätselement bzw. in dessen Segmente anlagern und somit wird das Volumen, welches die Vergussmasse im offenen Bereich des Gehäuses bildet, aufgeteilt und insbesondere in Kombination mit der stabilisierenden Wirkung des Stabilitätselementes können die Adhäsionskräfte der Vergussmasse zu den Gehäuse-Seitenflächen positiv beeinflusst werden, welches die Haftfestigkeit zwischen der Vergussmasse und den Seitenflächen erhöht.

Bevorzugt wird bei dem Verfahren das Stabilitätselement derart ausgestaltet, dass zwischen einem durch eine Umlaufkante des Stabilitätselementes gebildeten Rand und den inneren Oberflächen der Wände eine Fuge gebildet wird, in die die Vergussmasse eindringt. Während des Herstellungsprozesses, also kurz vor dem Vergießen der Vergussmasse, wird das Stabilitätselement, beispielsweise bei einem Gehäuse mit vier Seitenwänden und einem Boden, wobei der Deckel fehlt und damit die Gehäuseöffnung bildet, in der Öffnung derart platziert, dass von dem Rand des Stabilitätselements bis zu den inneren Seitenflächen des Gehäuses eine Fuge gebildet wird. Das Stabilitätselement ist damit in seinen Ausmaßen etwas geringer auszulegen, als es die Innenmaße der Gehäuseöffnung hergeben. Im Idealfall entsteht umlaufend eine Fuge mit einer gleichbleibenden Toleranz, beispielsweise einer Fugenbreite von 0,5 mm.

Bei dem Herstellungsverfahren ist es vorteilhaft, dass eine Füllmenge der Vergussmasse an die Verdrängung durch das Stabilitätselement angepasst wird, so dass die Vergussmasse nicht über das Gehäusevolumen hinaus fließt. Durch eine korrekte Auslegung der Füllhöhe der Vergussmasse wird bei Vorhandensein des Stabilitätselements der optische Eindruck des damit entstehenden Geräts nicht beeinträchtigt. Der Funktionsgewinn und die Qualitätssteigerung des Produkts hingegen werden erheblich verbessert.

Weitere Vorteile und Ausgestaltungsvarianten werden anhand der Zeichnung erläutert. Es zeigt:

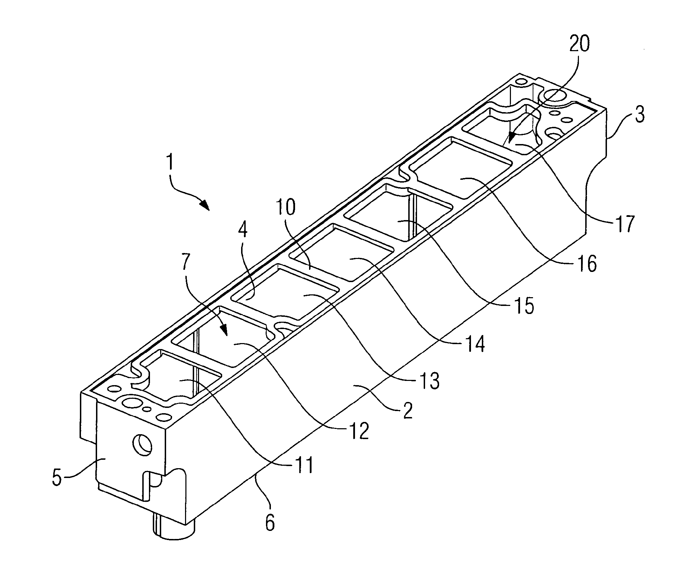

- FIG 1: ein Gehäuse mit Stabilitätselement in einer perspektivischen Ansicht.

Gemäß Figur 1 ist ein Gehäuse, welches ein Gerät 1 bildet, mit einer ersten Wand 2, einer zweiten Wand 3, einer dritten Wand 4, einer vierten Wand 5 und einem Boden 6 dargestellt. Das durch die Wände 2, 3, 4, 5 und dem Boden 6 gebildete kastenförmige Gehäuse ist dazu ausgestaltet, eine elektronische Einheit aufzunehmen. Zur Versorgung der elektronischen Einheiten mit Strom bzw. Signalleitungen sind an der Bodeneinheit, also im Boden 6, speziell abgedichtete Bohrungen vorgesehen, durch die Steckverbinder nach außen geführt werden können. Damit die innerhalb des Gehäusevolumens angeordnete elektrische Einheit vor schädlichen Umwelteinflüssen geschützt ist, ist das gesamte Gehäusevolumen mit einer Vergussmasse 7 aufgefüllt. Die Vergussmasse 7 umschließt dabei vollständig die elektrische Einheit. Aus Übersichtlichkeitsgründen ist die elektrische Einheit nicht dargestellt.

Um eine Haftfestigkeit zwischen der Vergussmasse 7 zu den inneren Oberflächen der Wände 2, 3, 4, 5, an welchen die Vergussmasse 7 anliegt, zu erhöhen, ist in der Ebene, welche durch die Öffnung 20 des Geräts 1 gebildet wird, ein Stabilitätselement 10 flächig angeordnet. Das Stabilitätselement 10 ist dabei aus zusammenhängenden Segmenten aufgebaut. Von links unten nach rechts oben in der Zeichnung gesehen schließt sich an ein erstes Segment 11 ein zweites Segment 12 an. An das zweite Segment 12 schließt sich wiederum ein drittes Segment 13 an. Dies setzt sich fort, bis ein siebtes Segment 17 das Stabilitätselement 10 in der Öffnung 20 des Geräts 1 in der oberen rechten Zeichnungsecke abschließt.

Das Stabilitätselement 10 weist weiterhin Ausnehmungen und Bohrungen auf, welche für später hinzuzufügende Befestigungselemente genutzt werden können. Durch die Aufteilung des Stabilitätselements 20 in die sieben Segmente 11 bis 17, wobei jedes Segment im Wesentlichen eine Rechteckform aufweist, wird das Volumen der Vergussmasse im oberen offenen Bereich des Gehäuses aufgeteilt in sieben kleinere Bereiche. In Kombination mit der stabilisierenden Wirkung des Stabilitätselements 10 wird damit erreicht, dass die Haftfestigkeit der Vergussmasse 7 zu den inneren Oberflächen der Wände 2, 3, 4 und 5 erhöht wird. Die Adhäsionskräfte, welche zwischen der Vergussmasse 7 und den inneren Oberflächen wirken, werden somit weniger gestört. Damit kann die Vergussmasse 7 schädlichen Umwelteinflüssen länger standhalten und gewährleistet somit einen Schutz innerhalb der Vergussmasse 7 und des Gehäuses angeordneten elektrischen Einheit.

Das Stabilitätselement 10 ist derart ausgestaltet, dass sein umlaufender Rand, innerhalb dessen sich die sieben Segmente befinden, keinen direkten Kontakt zu den Seitenflächen 2, 3, 4 und 5 aufweist, weiterhin lassen seine äußeren Abmessungen es zu, dass zwischen dem Rand des Stabilitätselements 10 und den inneren Oberflächen der Wände 2, 3, 4, 5 jeweils eine ca. 0,5 mm breite Fuge gebildet wird. In diese Fuge kann während bzw. nach dem Vergießen die Vergussmasse 7 eindringen und füllt damit einen bewusst klein gehaltenen Bereich aus. Ein derartig kleiner, mit Vergussmasse gefüllter Bereich kann einerseits die während der Schrumpfung auftretenden Kräfte besser verteilen und andererseits aufgrund seiner geringen Ausdehnung die Volumen- und damit einhergehende Längenänderung verringern, und einer Ablösung der Vergussmasse 7 von den Seitenwänden somit positiv entgegenwirken.

## Patentansprüche

1. Gerät (1) mit einem Gehäuse, welches ein Volumen begrenzende Wände (2, 3, 4, 5) zur Aufnahme einer technischen Einheit aufweist, wobei das Volumen zumindest teilweise mit einer Vergussmasse (7) ausgefüllt ist,
**dadurch gekennzeichnet, dass** zur Erhöhung einer Haftfestigkeit zwischen den inneren Oberflächen der Wände (2, 3, 4, 5) und der Vergussmasse (7) ein Stabilitätselement (10) in der Vergussmasse (7) angeordnet ist.

2. Gerät (1) nach Anspruch 1, wobei das Stabilitätselement (10) in zusammenhängende Segmente (11, ..., 17) aufgeteilt ist.

3. Gerät (1) nach Anspruch 1 oder 2, wobei das Stabilitätselement (10) eine gitterförmige Struktur aufweist und flächig ausgeprägt ist.

4. Gerät (1) nach Anspruch 3, wobei der Umfang des flächigen, gitterförmigen Stabilitätselements (10) an den Verlauf einer Öffnung (20) des Gehäuses angepasst ist.

5. Gerät (1) nach Anspruch 4, wobei das Stabilitätselement (10) oberflächennahe in der Öffnung (20) des Gehäuses (1) angeordnet ist.

6. Gerät (1) nach einem der Ansprüche 1 bis 5, wobei das Stabilitätselement (10) derart ausgestaltet ist, dass zwischen einem durch eine Umlaufkante des Stabilitätselementes (10) gebildeten Rand und den inneren Oberflächen der Wände (2, 3, 4, 5) eine Fuge entsteht, in die die Vergussmasse (7) eindringbar ist.

7. Gerät (1) nach einem der Ansprüche 1 bis 6, wobei die Vergussmasse (7) ein Kunstharz ist.

8. Gerät (1) nach einem der Ansprüche 1 bis 7, wobei die technische Einheit als eine elektronische Baugruppe ausgestaltet ist.

9. Verfahren zum Herstellen eines eine technische Einheit aufweisendes Gerätes (1), wobei das Gerät (1) durch ein Gehäuse mit ein Volumen begrenzende Wände (2, 3, 4, 5) zur Aufnahme der technischen Einheit gebildet wird, wobei das Volumen zumindest teilweise mit einer Vergussmasse (7) über eine Öffnung (20) des Gehäuses aufgefüllt wird,
**dadurch gekennzeichnet, dass** zur Erhöhung einer Haftfestigkeit zwischen den inneren Oberflächen der Wände (2, 3, 4, 5) und der Vergussmasse (7) ein Stabilitätselement (10) vor Vergießen der Vergussmasse (7) in das Volumen eingefügt wird.

10. Verfahren nach Anspruch 9, wobei das Stabilitätselement (10) derart ausgestaltet wird, dass zwischen einem durch eine Umlaufkante des Stabilitätselementes (10) gebildeten Rand und den durch die inneren Oberflächen der Wände (2, 3, 4, 5) eine Fuge gebildet wird, in die die Vergussmasse (7) eindringt.

11. Verfahren nach Anspruch 9 oder 10, wobei eine Füllmenge der Vergussmasse (7) an die Verdrängung durch das Stabilitätselement (10) angepasst wird, so dass die Vergussmasse (7) nicht über das Gehäusevolumen hinaus fließt.
